(19) Europäisches Patentamt

European Patent Office

Office européen des brevets

(11) **EP 4 006 641 A1**

(12) **EUROPEAN PATENT APPLICATION**

(43) Date of publication:
**01.06.2022  Bulletin 2022/22**

(21) Application number: **20210697.7**

(22) Date of filing: **30.11.2020**

(51) International Patent Classification (IPC):
**G03F 7/20** (2006.01)    **G02F 1/35** (2006.01)

(52) Cooperative Patent Classification (CPC):
**G03F 7/70616; G03F 7/70025;** G02F 1/354

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicants:
  • **Stichting Nederlandse Wetenschappelijk Onderzoek Instituten**
    **3526 KV Utrecht (NL)**
  • **ASML Netherlands B.V.**
    **5500 AH Veldhoven (NL)**
  • **Stichting VU**
    **1081 HV Amsterdam (NL)**
  • **Universiteit van Amsterdam**
    **1012 WX Amsterdam (NL)**

(72) Inventors:
  • **KRAUS, Peter, Michael**
    **3526 KV Utrecht (NL)**

  • **ROSCAM ABBING, Sylvianne, Dorothea, Christina**
    **1081 HV Amsterdam (NL)**
  • **CAMPI, Filippo**
    **3526 KV Utrecht (NL)**
  • **ZHANG, ZhuangYan**
    **3526 KV Utrecht (NL)**
  • **SMORENBURG, Petrus, Wilhelmus**
    **5500 AH Veldhoven (NL)**
  • **LIN, Nan**
    **5500 AH Veldhoven (NL)**
  • **WITTE, Stefan, Michiel**
    **1081 HV Amsterdam (NL)**
  • **DEN BOEF, Arie, Jeffrey**
    **5500 AH Veldhoven (NL)**

(74) Representative: **ASML Netherlands B.V.**
**Corporate Intellectual Property**
**P.O. Box 324**
**5500 AH Veldhoven (NL)**

(54) **METROLOGY APPARATUS BASED ON HIGH HARMONIC GENERATION AND ASSOCIATED METHOD**

(57)    Disclosed is a metrology apparatus for measurement of a target formed on a substrate by a lithographic process and associated method. The metrology apparatus comprises a radiation source operable to provide first radiation; a configured solid high harmonic generation medium being configured to receive and be excited by said first radiation to generate high harmonic second radiation from an output surface of the configured solid high harmonic generation medium; and a detection arrangement operable to detect said second radiation, at least a portion of which having been scattered by said target. The configured solid high harmonic generation medium is configured to shape the beam of said second radiation and/or separate said first and second radiation.

Fig. 7

EP 4 006 641 A1

## Description

FIELD

The present invention relates to methods and apparatus for metrology usable, for example, in the manufacture of devices by lithographic techniques.

BACKGROUND

A lithographic apparatus is a machine constructed to apply a desired pattern onto a substrate. A lithographic apparatus can be used, for example, in the manufacture of integrated circuits (ICs). A lithographic apparatus may, for example, project a pattern (also often referred to as "design layout" or "design") at a patterning device (e.g., a mask) onto a layer of radiation-sensitive material (resist) provided on a substrate (e.g., a wafer).

To project a pattern on a substrate a lithographic apparatus may use electromagnetic radiation. The wavelength of this radiation determines the minimum size of features which can be formed on the substrate. Typical wavelengths currently in use are 365 nm (i-line), 248 nm, 193 nm and 13.5 nm. A lithographic apparatus, which uses extreme ultraviolet (EUV) radiation, Such an apparatus may use a wavelength within the range 4-20 nm, for example 6.7 nm or 13.5 nm, to form smaller features on a substrate than a lithographic apparatus which uses, for example, radiation with a wavelength of 193 nm.

Low-ki lithography may be used to process features with dimensions smaller than the classical resolution limit of a lithographic apparatus. In such process, the resolution formula may be expressed as $CD = k_1 \times \lambda/NA$, where $\lambda$ is the wavelength of radiation employed, NA is the numerical aperture of the projection optics in the lithographic apparatus, CD is the "critical dimension" (generally the smallest feature size printed, but in this case half-pitch) and ki is an empirical resolution factor. In general, the smaller ki the more difficult it becomes to reproduce the pattern on the substrate that resembles the shape and dimensions planned by a circuit designer in order to achieve particular electrical functionality and performance. To overcome these difficulties, sophisticated fine-tuning steps may be applied to the lithographic projection apparatus and/or design layout. These include, for example, but not limited to, optimization of NA, customized illumination schemes, use of phase shifting patterning devices, various optimization of the design layout such as optical proximity correction (OPC, sometimes also referred to as "optical and process correction") in the design layout, or other methods generally defined as "resolution enhancement techniques" (RET). Alternatively, tight control loops for controlling a stability of the lithographic apparatus may be used to improve reproduction of the pattern at low k1.

In lithographic processes, it is desirable frequently to make measurements of the structures created, e.g., for process control and verification. Various tools for making such measurements are known, including scanning electron microscopes, which are often used to measure critical dimension (CD), and specialized tools to measure overlay, the accuracy of alignment of two layers in a device. Recently, various forms of scatterometers have been developed for use in the lithographic field.

Examples of known scatterometers often rely on provision of dedicated metrology targets. For example, a method may require a target in the form of a simple grating that is large enough that a measurement beam generates a spot that is smaller than the grating (i.e., the grating is underfilled). In so-called reconstruction methods, properties of the grating can be calculated by simulating interaction of scattered radiation with a mathematical model of the target structure. Parameters of the model are adjusted until the simulated interaction produces a diffraction pattern similar to that observed from the real target.

In addition to measurement of feature shapes by reconstruction, diffraction-based overlay can be measured using such apparatus, as described in published patent application US2006066855A1. Diffraction-based overlay metrology using dark-field imaging of the diffraction orders enables overlay measurements on smaller targets. These targets can be smaller than the illumination spot and may be surrounded by product structures on a wafer. Examples of dark field imaging metrology can be found in numerous published patent applications, such as for example US2011102753A1 and US20120044470A. Multiple gratings can be measured in one image, using a composite grating target. The known scatterometers tend to use light in the visible or near-IR wave range, which requires the pitch of the grating to be much coarser than the actual product structures whose properties are actually of interest. Such product features may be defined using deep ultraviolet (DUV), extreme ultraviolet (EUV) or X-ray radiation having far shorter wavelengths. Unfortunately, such wavelengths are not normally available or usable for metrology.

On the other hand, the dimensions of modern product structures are so small that they cannot be imaged by optical metrology techniques. Small features include for example those formed by multiple patterning processes, and/or pitch-multiplication. Hence, targets used for high-volume metrology often use features that are much larger than the products whose overlay errors or critical dimensions are the property of interest. The measurement results are only indirectly related to the dimensions of the real product structures, and may be inaccurate because the metrology target does not suffer the same distortions under optical projection in the lithographic apparatus, and/or different processing in other steps of the manufacturing process. While scanning electron microscopy (SEM) is able to resolve these modern product structures directly, SEM is much more time consuming than optical measurements. Moreover, electrons are not able to penetrate through thick process layers, which makes them less suitable for metrology applications. Other techniques, such as measuring electrical properties using contact pads is also known, but it provides only indirect evidence of the true product structure.

By decreasing the wavelength of the radiation used during metrology (i.e. moving towards the "soft X-ray" wavelength spectrum), it is possible to resolve smaller structures, to increase sensitivity to structural variations of the structures and/or penetrate further into the product structures. One such method of generating suitably high frequency radiation (e.g., soft X-ray and/or EUV radiation) may be using a pump radiation (e.g., infra-red radiation) to excite a generating medium, thereby generating an emitted radiation, optionally a high harmonic generation comprising high frequency radiation.

However, once generated, delivering the resultant SXR/EUV radiation to the target presents difficulties as it is readily absorbed.

SUMMARY

In a first aspect of the invention, there is provided a metrology apparatus for measurement of a target formed on a substrate by a lithographic process, the metrology apparatus comprising: a radiation source operable to provide first radiation; a configured solid high harmonic generation medium being configured to receive and be excited by said first radiation to generate high harmonic second radiation from an output surface of the configured solid high harmonic generation medium; and a detection arrangement operable to detect said second radiation, at least a portion of which having been scattered by said target; wherein said configured solid high harmonic generation medium is configured to shape the beam of said second radiation and/or separate said first and second radiation.

In a second aspect of the invention, there is provided a configured solid high harmonic generation medium comprising an axicon shape operable to impart an annular profile onto first radiation received at an input surface; and concentric circular grooves on an output surface such that high harmonic second radiation generated at said output surface resulting from excitation by said first radiation is focused on and/or propagates along an optical axis of the configured solid high harmonic generation medium.

In a third aspect of the invention there is provided, a metrology method for measuring a target formed on a substrate by a lithographic process comprising: exciting a configured solid high harmonic generation medium with first radiation, to generate high harmonic second radiation from an output surface of the configured solid high harmonic generation medium and to shape the beam of said second radiation and/or separate said first radiation and said second radiation; and detecting said second radiation, at least a portion of which having been scattered by said target.

In a fourth aspect of the invention, there is provided a configured solid high harmonic generation medium comprising an input surface operable to receive a first radiation; and an output surface operable to emit a high harmonic second radiation resulting from excitation by the first radiation. The configured solid high harmonic generation medium is configured to shape beam of the second radiation and/or separate the first radiation and the second radiation.

BRIEF DESCRIPTION OF THE DRAWINGS

Embodiments will now be described, by way of example only, with reference to the accompanying schematic drawings, in which:

- Figure 1 depicts a schematic overview of a lithographic apparatus;
- Figure 2 depicts a schematic overview of a lithographic cell;
- Figure 3 depicts a schematic representation of holistic lithography, representing a cooperation between three key technologies to optimize semiconductor manufacturing;
- Figure 4 schematically illustrates a scatterometry apparatus;
- Figure 5 depicts a schematic representation of a metrology apparatus in which EUV and/or SXR radiation is used;
- Figure 6 depicts a schematic representation of a metrology apparatus according to embodiments of the invention;
- Figure 7 depicts a schematic representation of an illumination source for high harmonic generation usable in metrology devices according to embodiments of the invention ;
- Figure 8 (a) and (b) respectively show a configured solid high harmonic generation medium usable in embodiments of the invention, in a first configuration and a second configuration;
- Figure 9 (a) and (b) schematically illustrates two different embodiments of a solid high harmonic generation medium which focusses the output radiation;
- Figure 10 schematically illustrates an axicon solid high harmonic generation medium according to an embodiment of the invention; and
- Figure 11 schematically illustrates a solid high harmonic generation medium for generating a flat-top output beam in an embodiment of the invention.

DETAILED DESCRIPTION

In the present document, the terms "radiation" and "beam" are used to encompass all types of electromagnetic radiation and particle radiation, including ultraviolet radiation (e.g. with a wavelength of 365, 248, 193, 157 or 126 nm), EUV (extreme ultra-violet radiation, e.g. having a wavelength in the range of about 5-125 nm or 5 to 100nm), X-ray radiation, electron beam radiation and other particle radiation.

The term "reticle", "mask" or "patterning device" as employed in this text may be broadly interpreted as referring to a generic patterning device that can be used to endow an incoming radiation beam with a patterned cross-section, corresponding to a pattern that is to be created in a target portion of the substrate. The term "light valve" can also be used in this context. Besides the classic mask (transmissive or reflective, binary, phase-shifting, hybrid, etc.), examples of other such patterning devices include a programmable mirror array and a programmable LCD array.

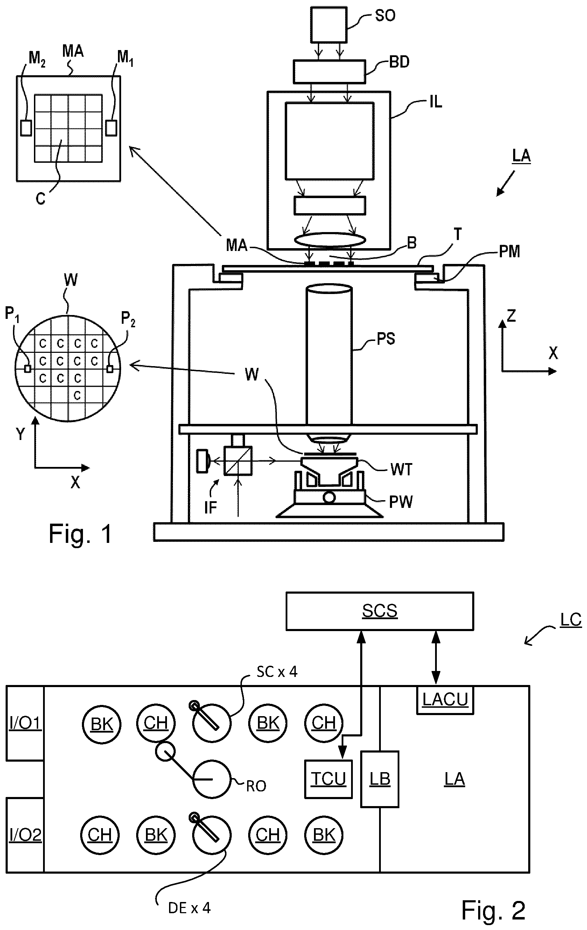

Figure 1 schematically depicts a lithographic apparatus LA. The lithographic apparatus LA includes an illumination system (also referred to as illuminator) IL configured to condition a radiation beam B (e.g., UV radiation, DUV radiation, EUV radiation or X-ray radiation), a mask support (e.g., a mask table) T constructed to support a patterning device (e.g., a mask) MA and connected to a first positioner PM configured to accurately position the patterning device MA in accordance with certain parameters, a substrate support (e.g., a wafer table) WT constructed to hold a substrate (e.g., a resist coated wafer) W and connected to a second positioner PW configured to accurately position the substrate support in accordance with certain parameters, and a projection system (e.g., a refractive projection lens system) PS configured to project a pattern imparted to the radiation beam B by patterning device MA onto a target portion C (e.g., comprising one or more dies) of the substrate W.

In operation, the illumination system IL receives a radiation beam from a radiation source SO, e.g. via a beam delivery system BD. The illumination system IL may include various types of optical components, such as refractive, reflective, diffractive, magnetic, electromagnetic, electrostatic, and/or other types of optical components, or any combination thereof, for directing, shaping, and/or controlling radiation. The illuminator IL may be used to condition the radiation beam B to have a desired spatial and angular intensity distribution in its cross section at a plane of the patterning device MA.

The term "projection system" PS used herein should be broadly interpreted as encompassing various types of projection system, including refractive, reflective, diffractive, catadioptric, anamorphic, magnetic, electromagnetic and/or electrostatic optical systems, or any combination thereof, as appropriate for the exposure radiation being used, and/or for other factors such as the use of an immersion liquid or the use of a vacuum. Any use of the term "projection lens" herein may be considered as synonymous with the more general term "projection system" PS.

The lithographic apparatus LA may be of a type wherein at least a portion of the substrate may be covered by a liquid having a relatively high refractive index, e.g., water, so as to fill a space between the projection system PS and the substrate W - which is also referred to as immersion lithography. More information on immersion techniques is given in US6952253, which is incorporated herein by reference in its entirety.

The lithographic apparatus LA may also be of a type having two or more substrate supports WT (also named "dual stage"). In such "multiple stage" machine, the substrate supports WT may be used in parallel, and/or steps in preparation of a subsequent exposure of the substrate W may be carried out on the substrate W located on one of the substrate support WT while another substrate W on the other substrate support WT is being used for exposing a pattern on the other substrate W.

In addition to the substrate support WT, the lithographic apparatus LA may comprise a measurement stage. The measurement stage is arranged to hold a sensor and/or a cleaning device. The sensor may be arranged to measure a property of the projection system PS or a property of the radiation beam B. The measurement stage may hold multiple sensors. The cleaning device may be arranged to clean part of the lithographic apparatus, for example a part of the projection system PS or a part of a system that provides the immersion liquid. The measurement stage may move beneath the projection system PS when the substrate support WT is away from the projection system PS.

In operation, the radiation beam B is incident on the patterning device, e.g. mask, MA which is held on the mask support T, and is patterned by the pattern (design layout) present on patterning device MA. Having traversed the mask MA, the radiation beam B passes through the projection system PS, which focuses the beam onto a target portion C of the substrate W. With the aid of the second positioner PW and a position measurement system IF, the substrate support WT may be moved accurately, e.g., so as to position different target portions C in the path of the radiation beam B at a focused and aligned position. Similarly, the first positioner PM and possibly another position sensor (which is not explicitly depicted in Figure 1) may be used to accurately position the patterning device MA with respect to the path of the radiation beam B. Patterning device MA and substrate W may be aligned using mask alignment marks M1, M2 and substrate alignment marks PI, P2. Although the substrate alignment marks PI, P2 as illustrated occupy dedicated target portions, they may be located in spaces between target portions. Substrate alignment marks PI, P2 are known as scribe-lane alignment marks when these are located between the target portions C.

As shown in Figure 2 the lithographic apparatus LA may form part of a lithographic cell LC, also sometimes referred to as a lithocell or (litho)cluster, which often also includes apparatus to perform pre-and post-exposure processes on a substrate W. Conventionally these include spin coaters SC to deposit resist layers, developers DE to develop exposed resist, chill plates CH and bake plates BK, e.g. for conditioning the temperature of substrates W e.g. for conditioning solvents in the resist layers. A substrate handler, or robot, RO picks up substrates W from input/output ports I/O1, I/O2, moves them between the different process apparatus and delivers the substrates W to the loading bay LB of the lithographic apparatus LA. The devices in the lithocell, which are often also collectively referred to as the track, may be under the control of a track control unit TCU that in itself may be controlled by a supervisory control system SCS, which may also control the lithographic apparatus LA, e.g. via lithography control unit LACU.

In lithographic processes, it is desirable to make frequently measurements of the structures created, e.g., for process control and verification. Tools to make such measurement may be called metrology tools MT. Different types of metrology tools MT for making such measurements are known, including scanning electron microscopes or various forms of scatterometer metrology tools MT. Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in an image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure gratings using light from hard X-ray, soft X-ray, extreme ultraviolet and visible to near-IR wavelength range. In case that the radiation is hard X-ray or soft X-ray, optionally with a wavelength ranging from 0.01 to 10 nm, the aforementioned scatterometers may optionally be a small-angle X-ray scattering metrology tool.

In order for the substrates W exposed by the lithographic apparatus LA to be exposed correctly and consistently, it is desirable to inspect substrates to measure properties of patterned structures, such as overlay errors between subsequent layers, line thicknesses, critical dimensions (CD), shape of structures, etc. For this purpose, inspection tools and/or metrology tools (not shown) may be included in the lithocell LC. If errors are detected, adjustments, for example, may be made to exposures of subsequent substrates or to other processing steps that are to be performed on the substrates W, especially if the inspection is done before other substrates W of the same batch or lot are still to be exposed or processed.

An inspection apparatus, which may also be referred to as a metrology apparatus, is used to determine properties of the substrates W, and in particular, how properties of different substrates W vary or how properties associated with different layers of the same substrate W vary from layer to layer. The inspection apparatus may alternatively be constructed to identify defects on the substrate W and may, for example, be part of the lithocell LC, or may be integrated into the lithographic apparatus LA, or may even be a stand-alone device. The inspection apparatus may measure the properties on a latent image (image in a resist layer after the exposure), or on a semilatent image (image in a resist layer after a post-exposure bake step PEB), or on a developed resist image (in which the exposed or unexposed parts of the resist have been removed), or even on an etched image (after a pattern transfer step such as etching).

In a first embodiment, the scatterometer MT is an angular resolved scatterometer. In such a scatterometer reconstruction methods may be applied to the measured signal to reconstruct or calculate properties of the grating. Such reconstruction may, for example, result from simulating interaction of scattered radiation with a mathematical model of the target structure and comparing the simulation results with those of a measurement. Parameters of the mathematical model are adjusted until the simulated interaction produces a diffraction pattern similar to that observed from the real target.

In a second embodiment, the scatterometer MT is a spectroscopic scatterometer MT. In such spectroscopic scatterometer MT, the radiation emitted by a radiation source is directed onto the target and the reflected, transmitted or scattered radiation from the target is directed to a spectrometer detector, which measures a spectrum (i.e. a measurement of intensity as a function of wavelength) of the specular reflected radiation. From this data, the structure or profile of the target giving rise to the detected spectrum may be reconstructed, e.g. by Rigorous Coupled Wave Analysis and non-linear regression or by comparison with a library of simulated spectra.

In a third embodiment, the scatterometer MT is an ellipsometric scatterometer. The ellipsometric scatterometer allows for determining parameters of a lithographic process by measuring scattered or transmitted radiation for each polarization states. Such metrology apparatus emits polarized light (such as linear, circular, or elliptic) by using, for example, appropriate polarization filters in the illumination section of the metrology apparatus. A source suitable for the metrology apparatus may provide polarized radiation as well. Various embodiments of existing ellipsometric scatterometers are described in US patent applications 11/451,599, 11/708,678, 12/256,780, 12/486,449, 12/920,968, 12/922,587, 13/000,229, 13/033,135, 13/533,110 and 13/891,410 incorporated herein by reference in their entirety.

In one embodiment of the scatterometer MT, the scatterometer MT is adapted to measure the overlay of two misaligned gratings or periodic structures by measuring asymmetry in the reflected spectrum and/or the detection configuration, the asymmetry being related to the extent of the overlay. The two (maybe overlapping) grating structures may be applied in two different layers (not necessarily consecutive layers), and may be formed substantially at the same position on the wafer. The scatterometer may have a symmetrical detection configuration as described e.g. in co-owned patent application EP1,628,164A, such that any asymmetry is clearly distinguishable. This provides a straightforward way to measure misalignment in gratings. Further examples for measuring overlay error between the two layers containing periodic structures as target is measured through asymmetry of the periodic structures may be found in PCT patent application publication no. WO 2011/012624 or US patent application US 20160161863, incorporated herein by reference in its entirety.

Other parameters of interest may be focus and dose. Focus and dose may be determined simultaneously by scatterometry (or alternatively by scanning electron microscopy) as described in US patent application US2011-0249244, incorporated herein by reference in its entirety. A single structure may be used which has a unique combination of critical dimension and sidewall angle measurements for each point in a focus energy matrix (FEM - also referred to as Focus Exposure Matrix). If these unique combinations of critical dimension and sidewall angle are available, the focus and dose values may be uniquely determined from these measurements.

A metrology target may be an ensemble of composite gratings, formed by a lithographic process, mostly in resist, but also after etch process for example. The pitch and line-width of the structures in the gratings may strongly depend on the measurement optics (in particular the NA of the optics) to be able to capture diffraction orders coming from the metrology targets. As indicated earlier, the diffracted signal may be used to determine shifts between two layers (also referred to 'overlay') or may be used to reconstruct at least part of the original grating as produced by the lithographic process. This reconstruction may be used to provide guidance of the quality of the lithographic process and may be used to control at least part of the lithographic process. Targets may have smaller sub-segmentation which are configured to mimic dimensions of the functional part of the design layout in a target. Due to this sub-segmentation, the targets will behave more similar to the functional part of the design layout such that the overall process parameter measurements resemble the functional part of the design layout better. The targets may be measured in an underfilled mode or in an overfilled mode. In the underfilled mode, the measurement beam generates a spot that is smaller than the overall target. In the overfilled mode, the measurement beam generates a spot that is larger than the overall target. In such overfilled mode, it may also be possible to measure different targets simultaneously, thus determining different processing parameters at the same time.

Overall measurement quality of a lithographic parameter using a specific target is at least partially determined by the measurement recipe used to measure this lithographic parameter. The term "substrate measurement recipe" may include one or more parameters of the measurement itself, one or more parameters of the one or more patterns measured, or both. For example, if the measurement used in a substrate measurement recipe is a diffraction-based optical measurement, one or more of the parameters of the measurement may include the wavelength of the radiation, the polarization of the radiation, the incident angle of radiation relative to the substrate, the orientation of radiation relative to a pattern on the substrate, etc. One of the criteria to select a measurement recipe may, for example, be a sensitivity of one of the measurement parameters to processing variations. More examples are described in US patent application US2016-0161863 and published US patent application US 2016/0370717A1 incorporated herein by reference in its entirety.

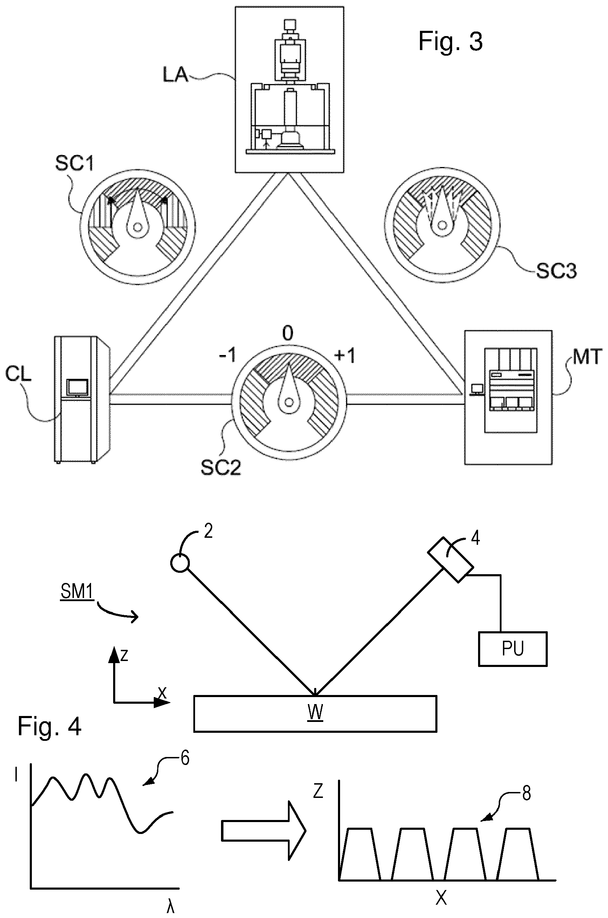

The patterning process in a lithographic apparatus LA may be one of the most critical steps in the processing which requires high accuracy of dimensioning and placement of structures on the substrate W. To ensure this high accuracy, three systems may be combined in a so called "holistic" control environment as schematically depicted in Fig. 3. One of these systems is the lithographic apparatus LA which is (virtually) connected to a metrology tool MT (a second system) and to a computer system CL (a third system). The key of such "holistic" environment is to optimize the cooperation between these three systems to enhance the overall process window and provide tight control loops to ensure that the patterning performed by the lithographic apparatus LA stays within a process window. The process window defines a range of process parameters (e.g. dose, focus, overlay) within which a specific manufacturing process yields a defined result (e.g. a functional semiconductor device) - maybe within which the process parameters in the lithographic process or patterning process are allowed to vary.

The computer system CL may use (part of) the design layout to be patterned to predict which resolution enhancement techniques to use and to perform computational lithography simulations and calculations to determine which mask layout and lithographic apparatus settings achieve the largest overall process window of the patterning process (depicted in Fig. 3 by the double arrow in the first scale SC1). The resolution enhancement techniques may be arranged to match the patterning possibilities of the lithographic apparatus LA. The computer system CL may also be used to detect where within the process window the lithographic apparatus LA is currently operating (e.g. using input from the metrology tool MET) to predict whether defects may be present due to e.g. sub-optimal processing (depicted in Fig. 3 by the arrow pointing "0" in the second scale SC2).

The metrology tool MT may provide input to the computer system CL to enable accurate simulations and predictions, and may provide feedback to the lithographic apparatus LA to identify possible drifts, e.g. in a calibration status of the lithographic apparatus LA (depicted in Fig. 3 by the multiple arrows in the third scale SC3).

In lithographic processes, it is desirable to make frequently measurements of the structures created, e.g.,

for process control and verification. Various tools for making such measurements are known, including scanning electron microscopes or various forms of metrology apparatuses, such as scatterometers. Examples of known scatterometers often rely on provision of dedicated metrology targets, such as underfilled targets (a target, in the form of a simple grating or overlapping gratings in different layers, that is large enough that a measurement beam generates a spot that is smaller than the grating) or overfilled targets (whereby the illumination spot partially or completely contains the target). Further, the use of metrology tools, for example an angular resolved scatterometer illuminating an underfilled target, such as a grating, allows the use of so-called reconstruction methods where the properties of the grating may be calculated by simulating interaction of scattered radiation with a mathematical model of the target structure and comparing the simulation results with those of a measurement. Parameters of the model are adjusted until the simulated interaction produces a diffraction pattern similar to that observed from the real target.

Scatterometers are versatile instruments which allow measurements of the parameters of a lithographic process by having a sensor in the pupil or a conjugate plane with the pupil of the objective of the scatterometer, measurements usually referred as pupil based measurements, or by having the sensor in the image plane or a plane conjugate with the image plane, in which case the measurements are usually referred as image or field based measurements. Such scatterometers and the associated measurement techniques are further described in patent applications US20100328655, US2011102753A1, US20120044470A, US20110249244, US20110026032 or EP1,628,164A, incorporated herein by reference in their entirety. Aforementioned scatterometers may measure in one image multiple targets from multiple gratings using light from hard X-ray, soft X-ray, extreme ultraviolet and visible to near-IR wave range.

One example of a metrology apparatus, such as a scatterometer, is depicted in Figure 4. It may comprise a broadband (e.g. white light) radiation projector 2 which projects radiation 5 onto a substrate W. The reflected or scattered radiation 10 is passed to a spectrometer detector 4, which measures a spectrum 6 (i.e. a measurement of intensity I as a function of wavelength λ) of the specular reflected radiation. From this data, the structure or profile 8 giving rise to the detected spectrum may be reconstructed by processing unit PU, e.g. by Rigorous Coupled Wave Analysis and non-linear regression or by comparison with a library of simulated spectra as shown at the bottom of Figure 4. In general, for the reconstruction, the general form of the structure is known and some parameters are assumed from knowledge of the process by which the structure was made, leaving only a few parameters of the structure to be determined from the scatterometry data. Such a scatterometer may be configured as a normal-incidence scatterometer or an oblique-incidence scatterometer.

As an alternative to optical metrology methods, it has also been considered to use hard X-ray, soft X-rays or EUV radiation, for example radiation in a wavelength range between 0.01nm and 100nm, or optionally between 1nm and 50 nm or optionally between 10nm and 20nm. One example of metrology tool functioning in one of the above presented wavelength ranges is transmissive small angle X-ray scattering (T-SAXS as in US 2007224518A which content is incorporated herein by reference in its entirety). Profile (CD) measurements using T-SAXS are discussed by Lemaillet et al in "Intercomparison between optical and X-ray scatterometry measurements of FinFET structures", Proc. of SPIE, 2013, 8681. Reflectometry techniques using X-rays (GI-XRS) and extreme ultraviolet (EUV) radiation at grazing incidence are known for measuring properties of films and stacks of layers on a substrate. Within the general field of reflectometry, goniometric and/or spectroscopic techniques may be applied. In goniometry, the variation of a reflected beam with different incidence angles is measured. Spectroscopic reflectometry, on the other hand, measures the spectrum of wavelengths reflected at a given angle (using broadband radiation). For example, EUV reflectometry has been used for inspection of mask blanks, prior to manufacture of reticles (patterning devices) for use in EUV lithography.

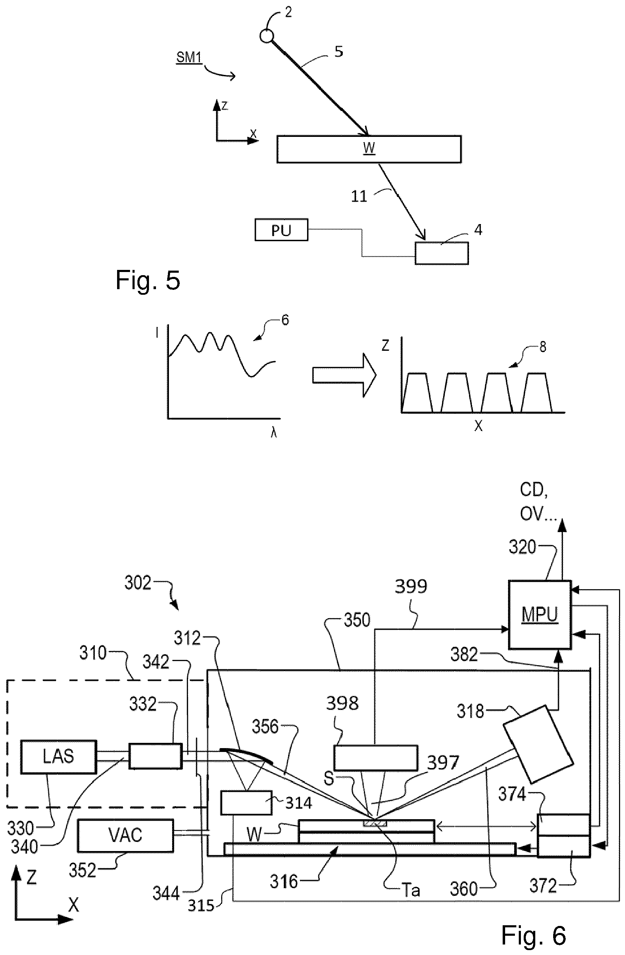

A transmissive version of the example of a metrology apparatus, such as a scatterometer, shown in Figure 4, is depicted in Figure 5. The transmitted radiation 11 is passed to a spectrometer detector 4, which measures a spectrum 6 as discussed for Figure 4. Such a scatterometer may be configured as a normal-incidence scatterometer or an oblique-incidence scatterometer.

It is possible that the range of application makes the use of wavelengths in e.g. the soft X-rays or EUV domain not sufficient. Therefore published patent applications US 20130304424A1 and US2014019097A1 (Bakeman et al/KLA) describe hybrid metrology techniques in which measurements made using x-rays and optical measurements with wavelengths in the range 120 nm and 2000 nm are combined together to obtain a measurement of a parameter such as CD. A CD measurement is obtained by coupling and x-ray mathematical model and an optical mathematical model through one or more common. The contents of the cited US patent application are incorporated herein by reference in their entirety.

SXR metrology (e.g., using wavelengths in the range of 1-100nm or 30-100nm) using HHG techniques partially resolve the problem of limited penetration depth of visible/NIR wavelength into the relevant materials, due to the larger penetration depth of SXR. It is also an all-optical method, thus measurements can be sufficiently fast for metrology in a high volume manufacturing environment, for example.

However, handling present HHG sources is technologically challenging. Such sources typically generate high harmonics from excitation of a gas medium, which presents difficulties in handling the gas. Also, HHG generation from gas media require a very high peak-powered drive laser. Furthermore, the setups are inflexible, as there are no good materials for SXR reflection, beam shaping etc. leading to a loss of photons.

In addition, there are no suitable vacuum XUV or EUV sources for metrology presently available (e.g., in the 30-100 nm wavelength range), even though such sources might be similarly beneficial as SXR, but less demanding in vacuum operation (at least for wavelengths greater than 60 nm, i.e., below the ionization threshold of most gases).

As such, a metrology apparatus and associated method is disclosed for measuring a metrology target on a substrate having been formed by a lithographic process, the metrology apparatus being configured to generate SXR or EUV high harmonic measurement radiation from a configured solid medium, wherein the configured solid medium is configured to adjust a property of the emitted measurement radiation such that it is more optimal for said measuring of the metrology target.

Figure 6 depicts a schematic representation of a metrology apparatus 302 in which radiation in the wavelength range from 0.1 nm to 100 nm may be used to measure parameters of structures on a substrate in accordance with concepts disclosed hereon. The metrology apparatus 302 presented in Figure 6 is suitable for the soft X-rays or EUV domain.

Figure 6 illustrates a schematic physical arrangement of a metrology apparatus 302 comprising a spectroscopic scatterometer using EUV and/or SXR radiation in grazing incidence, purely by way of example. An alternative form of inspection apparatus might be provided in the form of an angle-resolved scatterometer, which uses radiation in normal or near-normal incidence similar to the conventional scatterometers operating at longer wavelengths.

Inspection apparatus 302 comprises a radiation source or called illumination source 310, illumination system 312, substrate support 316, detection systems 318, 398 and metrology processing unit (MPU) 320.

An illumination source 310 in this example is for a generation of second radiation; e.g., EUV or soft x-ray radiation, which may be based on high harmonic generation (HHG) techniques. Main components of the radiation source are a pump radiation source 330 operable to emit the pump radiation or first radiation and a configured solid medium 332. Optionally the pump radiation source 330 is a laser, optionally the pump radiation source 330 is a pulsed high-power infrared or visible laser. The pump radiation source 330 may be, for example, a fiber-based laser with an optical amplifier, producing pulses of infrared radiation that may last for example less than 1 ns, less than 1ps or less that 100fs per pulse, with a pulse repetition rate up to several megahertz, as required. The wavelength of the infrared radiation may be for example in the region of 1 $\mu$m (1 micron). Optionally, the laser pulses are delivered as a first pump radiation 340 to the configured solid medium 332, wherein a portion of the radiation is converted by the configured solid medium 332 to higher frequencies than the first radiation into an emitted radiation 342.

The emitted radiation may contain multiple wavelengths. If the emitted radiation were monochromatic, then measurement calculations (for example reconstruction) may be simplified, but it is easier to produce radiation with several wavelengths. An emission divergence angle of the emitted radiation may be wavelength dependent. These may be selectable options within the same apparatus. Different wavelengths will, for example, provide different levels of contrast when imaging structure of different materials. For inspection of metal structures or silicon structures, for example, different wavelengths may be selected to those used for imaging features of (carbon-based) resist, or for detecting contamination of such different materials. One or more filtering devices 344 may be provided. For example a filter such as a thin membrane of Aluminum (Al) or Zirconium (Zr) may serve to cut the fundamental IR radiation from passing further into the inspection apparatus. A grating (not shown) may be provided to select one or more specific harmonic wavelengths from among those generated. Some or all of the beam path may be contained within a vacuum environment, bearing in mind that SXR radiation is absorbed when traveling in air. The various components of radiation source 310 and illumination optics 312 may be adjustable to implement different metrology 'recipes' within the same apparatus. For example different wavelengths and/or polarization may be made selectable.

Depending on the materials of the structure under inspection, different wavelengths may offer a desired level of penetration into lower layers. For resolving the smallest device features and defects among the smallest device features, then a short wavelength is likely to be preferred. For example, one or more wavelengths in the range 1-100nm, 1-50nm, 1-30nm, 1-20 nm or optionally in the range 1-10 nm or optionally in the range 10-20 nm may be chosen. Wavelengths shorter than 5 nm may suffer from very low critical angle when reflecting off materials of interest in semiconductor manufacture. Therefore to choose a wavelength greater than 5 nm will provide stronger signals at higher angles of incidence. On the other hand, if the inspection task is for detecting the presence of a certain material, for example to detect contamination, then wavelengths up to 50 nm could be useful.

From the radiation source 310, the filtered beam 342 may enter an inspection chamber 350 where the substrate W including a structure of interest is held for inspection at a measurement position by substrate support 316. The structure of interest is labeled T. The atmosphere within inspection chamber 350 may be maintained near vacuum by vacuum pump 352, so that generated high harmonic radiation may pass without undue attenuation through the atmosphere. The Illumination system 312 has the function of focusing the radiation into a focused beam 356, and may comprise for example a two-dimensionally curved mirror, or a series of one-dimensionally curved mirrors, as described in published US patent application US2017/0184981A1 (which content is incorporated herein by reference in its entirety), mentioned above. The focusing may be performed to achieve a round or elliptical spot S under 10 μm in diameter, when projected onto the structure of interest (e.g., to measure 10μm x 10μm targets; however the concepts herein may be used to measure larger targets comprising dimensions of 20μm, 30μm, 40μm or 50μm in one or both of the substrate plane dimensions).

In some embodiments, however, the focusing may be performed by the configured solid medium 332 and no curved mirror may be required.

Substrate support 316 comprises for example an X-Y translation stage and a rotation stage, by which any part of the substrate W may be brought to the focal point of beam to in a desired orientation. Thus the radiation spot S is formed on the structure of interest. Alternatively, or additionally, substrate support 316 comprises for example a tilting stage that may tilt the substrate W at a certain angle to control the angle of incidence of the focused beam on the structure of interest T.

Optionally, the illumination system 312 provides a reference beam of radiation to a reference detector 314 which may be configured to measure a spectrum and/or intensities of different wavelengths in the filtered beam 342. The reference detector 314 may be configured to generate a signal 315 that is provided to processor 310 and the filter may comprise information about the spectrum of the filtered beam 342 and/or the intensities of the different wavelengths in the filtered beam.

Reflected radiation 360 is captured by detector 318 and a spectrum is provided to processor 320 for use in calculating a property of the target structure T. The illumination system 312 and detection system 318 thus form an inspection apparatus. This inspection apparatus may comprise a soft X-ray and/or EUV spectroscopic reflectometer of the kind described in US2016282282A1 which content is incorporated herein by reference in its entirety.

If the target T has a certain periodicity, the radiation of the focused beam 356 may be partially diffracted as well. The diffracted radiation 397 follows another path at well-defined angles with respect to the angle of incidence then the reflected radiation 360. In Figure 6, the drawn diffracted radiation 397 is drawn in a schematic manner and diffracted radiation 397 may follow many other paths than the drawn paths. The inspection apparatus 302 may also comprise further detection systems 398 that detect and/or image at least a portion of the diffracted radiation 397. In Figure 6 a single further detection system 398 is drawn, but embodiments of the inspection apparatus 302 may also comprise more than one further detection system 398 that are arranged at different position to detect and/or image diffracted radiation 397 at a plurality of diffraction directions. In other words, the (higher) diffraction orders of the focused radiation beam that impinges on the target T are detected and/or imaged by one or more further detection systems 398. The one or more detection systems 398 generates a signal 399 that is provided to the metrology processor 320. The signal 399 may include information of the diffracted light 397 and/or may include images obtained from the diffracted light 397.

To aid the alignment and focusing of the spot S with desired product structures, inspection apparatus 302 may also provide auxiliary optics using auxiliary radiation under control of metrology processor 320. Metrology processor 320 may also communicate with a position controller 372 which operates the translation stage, rotation and/or tilting stages. Processor 320 receives highly accurate feedback on the position and orientation of the substrate, via sensors. Sensors 374 may include interferometers, for example, which may give accuracy in the region of picometers. In the operation of the inspection apparatus 302, spectrum data 382 captured by detection system 318 is delivered to metrology processing unit 320.

As mentioned an alternative form of inspection apparatus uses soft X-ray and/or EUV radiation at normal incidence or near-normal incidence, for example to perform diffraction-based measurements of asymmetry. Both types of inspection apparatus could be provided in a hybrid metrology system. Performance parameters to be measured may include overlay (OVL), critical dimension (CD), focus of the lithography apparatus while the lithography apparatus printed the target structure, coherent diffraction imaging (CDI) and at-resolution overlay (ARO) metrology. The soft X-ray and/or EUV radiation may for example have wavelengths less than 100 nm, for example using radiation in the range 5-30 nm, of optionally in the range from 10 nm to 20 nm. The radiation may be narrowband or broadband in character. The radiation may have discrete peaks in a specific wavelength band or may have a more continuous character.

Like the optical scatterometer used in today's production facilities, the inspection apparatus 302 may be used to measure structures within the resist material treated within the litho cell (After Develop Inspection or ADI), and/or to measure structures after they have been formed in harder material (After Etch Inspection or AEI). For example, substrates may be inspected using the inspection apparatus 302 after they have been processed by a developing apparatus, etching apparatus, annealing apparatus and/or other apparatus.

Metrology tools MT, including but not limited to the scatterometers mentioned above, may use radiation from a radiation source to perform a measurement. The radiation used by a metrology tool MT may be electromagnetic radiation. The radiation may be optical radiation, for example radiation in the infrared, visible, and/or ultraviolet parts of the electromagnetic spectrum. Metrology tools MT may use radiation to measure or inspect properties and aspects of a substrate, for example a lithographically exposed pattern on a semiconductor substrate. The type and quality of the measurement may depend on several properties of the radiation used by the metrology tool MT. For example, the resolution of an electromagnetic measurement may depend on the wavelength of the radiation, with smaller wavelengths able to measure smaller features, e.g. due to the diffraction limit. In order to measure features with small dimensions, it may be preferable to use radiation with a short wavelength, for example EUV and/or Soft X-Ray (SXR) radiation, to perform measurements. In order to perform metrology at a particular wavelength or wavelength range, the metrology tool MT requires access to a source providing radiation at that/those wavelength(s). Different types of sources exist for providing different wavelengths of radiation. Depending on the wavelength(s) provided by a source, different types of radiation generation methods may be used. For extreme ultraviolet (EUV) radiation (e.g. 1 nm to 100 nm), and/or soft X-ray (SXR) radiation (e.g. 0.1 nm to 10 nm), a source may use High Harmonic Generation (HHG) to obtain radiation at the desired wavelength(s). One of the challenges faced in the development of these sources is how to couple the emitted radiation out of the generating setup efficiently and separate the emitted radiation from the radiation used to drive the process.

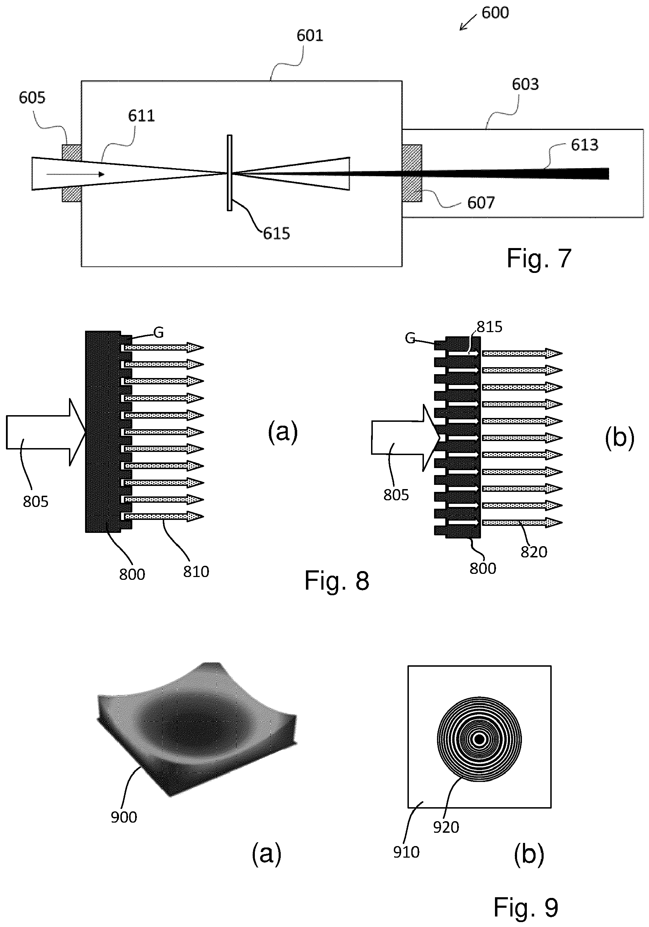

Figure 7 shows a simplified schematic drawing of an embodiment 600 of an illumination source 310, which may be the illumination source for high harmonic generation. One or more of the features of the illumination source in the metrology tool described with respect to Figures 7 may also be present in the illumination source 600 as appropriate. The illumination source 600 may comprise a chamber 601. The illumination source 600 is configured to receive first radiation or pump radiation 611 with a propagation direction which is indicated by an arrow. The pump radiation 611 shown here is an example of the pump radiation 340 from the pump radiation source 330, as shown in Figure 7. The pump radiation 611 may be directed into the chamber 601 through the radiation input 605, which maybe a viewport which may be made of fused silica or a comparable material. The pump radiation 611 may have a Gaussian or hollow, for example annular, transversal cross-sectional profile and may be incident, optionally focused, on a solid medium , optionally a configured solid medium 615, within the chamber 601.

The illumination source 600 is configured to provide the pump radiation 611 to the configured solid medium 615 to drive the generation of second radiation or high harmonic emitted radiation 613. In case of generating HHG from a solid medium, the penetration depth of the generated radiation through the solid medium is very short, so that only the radiation generated in a thin layer near the downstream surface will emerge from the medium. Typical penetration depths are on the order of 5-500 nm.

Due to interaction of the pump radiation 611 with the atoms of the configured solid medium 615, the configured solid medium 615 will convert part of the pump radiation 611 into the emitted radiation 613, which may be an example of the emitted radiation 342 shown in Figure 6. The central axes of the emitted radiation 613 may be collinear with the central axes of the incident pump radiation 611. The emitted radiation 613 may have a wavelength in X-ray or EUV range, wherein the wavelength is in a range from 0.01 nm to 100 nm, optionally from 0.1 nm to 100 nm, optionally from 1 nm to 100 nm, optionally from 1 nm to 50 nm, or optionally from 10 nm to 20 nm. In addition, or alternatively, the emitted radiation 613 may be generated from the lower harmonics of the "high harmonic radiation" (e.g., 3rd, 5th harmonics etc.) such that the emitted radiation comprises wavelengths in the VUV-UV range; e.g., in the range 100nm to 400 nm.

In operation the emitted radiation 613 beam may pass through a radiation output 607 and may be subsequently manipulated and directed by an illumination system 603, which may be an example of the illumination system 312 in Figure 6, to a wafer to be inspected for metrology measurements. The emitted radiation 613 may be guided, optionally focused, to a target on the wafer.

Because air (and in fact any gas) heavily absorbs SXR or EUV radiation, the volume between the gas flow 615 and the wafer to be inspected may be evacuated or nearly evacuated. Since the central axes of the emitted radiation 613 may be collinear with the central axes of the incident pump radiation 611, the pump radiation 611 may need to be blocked to prevent it passing through the radiation output 607 and entering the illumination system 603. This may be done by incorporating a filtering device 344 shown in Figure 6 into the radiation output 607, which is placed in the emitted beam path and that is opaque or nearly opaque to the driving radiation (e.g. opaque or nearly opaque to infrared or visible light) but at least partially transparent to the emitted radiation beam. The filter may be manufactured using zirconium. The filter may be a hollow, optionally an annular, block when the pump radiation 611 has a hollow, optionally an annular, transversal cross-sectional profile.

Described herein are methods, apparatuses, and assemblies to obtain emitted radiation optionally at a high harmonic frequency of pump radiation. The radiation generated through the process, optionally the HHG which uses non-linear effects to generate radiation at a harmonic frequency of provided pump radiation, may be provided as radiation in metrology tools MT for inspection and/or measurement of substrates. The substrates may be lithographically patterned substrates. The radiation obtained through the process may also be provided in a lithographic apparatus LA, and/or a lithographic cell LC. The pump radiation may be pulsed radiation, which may provide high peak intensities for short bursts of time.

The pump radiation 611 may comprise radiation with one or more wavelengths higher than the one or more wavelengths of the emitted radiation. The pump radiation may comprise infrared radiation. The pump radiation may comprise radiation with wavelength(s) in the range of 800 nm to 1500 nm. The pump radiation may comprise radiation with wavelength(s) in the range of 900 nm to 1300 nm. The pump radiation may comprise radiation with wavelength(s) in the range of 100 nm to 1300 nm. The pump radiation may be pulsed radiation. Pulsed pump radiation may comprise pulses with a duration in the femtosecond range.

For some embodiments, the emitted radiation, optionally the high harmonic radiation, may comprise one or more harmonics of the pump radiation wavelength(s). The emitted radiation may comprise wavelengths in the extreme ultraviolet (EUV), soft X-Ray (SXR), and/or hard X-Ray part of the electromagnetic spectrum. The emitted radiation 613 may comprise wavelengths in the range of 0.01 nm to 100 nm. The emitted radiation 613 may comprise wavelengths in the range of 0.1 nm to 100 nm. The emitted radiation 613 may comprise wavelengths in the range of 0.1 nm to 50 nm. The emitted radiation 613 may comprise wavelengths in the range of 1 nm to 50 nm. The emitted radiation 613 may comprise wavelengths in the range of 10 nm to 20 nm.

Radiation, such as high harmonic radiation described above, may be provided as source radiation in a metrology tool MT. The metrology tool MT may use the source radiation to perform measurements on a substrate exposed by a lithographic apparatus. The measurements may be for determining one or more parameters of a structure on the substrate. Using radiation at shorter wavelengths, for example at EUV and/or SXR wavelengths as comprised in the wavelength ranges described above, may allow for smaller features of a structure to be resolved by the metrology tool, compared to using longer wavelengths (e.g. visible radiation, infrared radiation). Radiation with shorter wavelengths, such as EUV and/or SXR radiation, may also penetrate deeper into a material such as a patterned substrate, meaning that metrology of deeper layers on the substrate is possible. These deeper layers may not be accessible by radiation with longer wavelengths.

In a metrology tool MT, source radiation may be emitted from a radiation source and directed onto a target structure (or other structure) on a substrate. The source radiation may comprise EUV and/or SXR radiation. The target structure may reflect and/or diffract the source radiation incident on the target structure. The metrology tool MT may comprise one or more sensors for detecting diffracted radiation. For example, a metrology tool MT may comprise detectors for detecting the positive (+1st) and negative (-1st) first diffraction orders. The metrology tool MT may also measure the specular reflected radiation (0th order diffracted radiation). Further sensors for metrology may be present in the metrology tool MT, for example to measure further diffraction orders (e.g. higher diffraction orders).

It is proposed to incorporate together at least one optical element with the generation medium of broadband SXR and/or EUV radiation, by generating the broadband SXR and/or EUV radiation (second radiation) by excitation of a configured medium, e.g., a spatially structured dielectric, using first radiation or drive radiation (e.g., having a wavelength between 100nm and 3000nm, between 400nm and 3000nm or between 800nm and 3000nm).

The frequency up-conversion to multiple harmonics of the fundamental beam has recently been demonstrated in solids. While initially demonstrated in the visible and near ultraviolet spectral region, extreme ultraviolet generation from solids up to 40 eV (30 nm) has recently become possible. The conversion efficiency of the process in solids is lower than for gas phase HHG in the same photon energy range; however, this can be addressed by using intracavity HHG techniques, which would compensate for the comparatively low conversion efficiency. Non-collinear HHG wavemixing in solids is another way to boost the conversion efficiency; e.g., as disclosed by P. M. Kraus in Ultrafast extreme-ultraviolet emission from solids, EUV Source Workshop Proceedings, 04.11.2020. The proceedings are available at https://euvlitho.com/_and are incorporated herein by reference.

In addition, HHG reflection and beam shaping systems have low transmission (reflection) efficiencies due to the poor reflectivity and transmission of materials in this spectral range. By integrating the generating and beam shaping process into a single element, HHG setups become smaller, cheaper, easier to maintain, while possibly retaining the same flux as gas phase systems. Furthermore, HHG beam shaping by structuring the generating solid element allows for far more detailed and high-resolution beam shaping than free-space optics.

Figure 8 illustrates a first embodiment of a configured solid HHG medium 800 for generating spatially structured light. A grating structure G is imprinted on a structured side of a fused silica substrate (e.g., in the region of 0.1 mm thick) and HHG is generated from this structure. Figure 8(a) illustrates the configured solid HHG medium 800 in a first orientation, oriented to receive first radiation or drive radiation 805 on the unstructured side. In this orientation, the HHG occurs on the structured side and a phase grating or phase modulation is imposed on the output SXR/EUV radiation 810; noting that the attenuation length of the extreme ultraviolet radiation is <100 nm and therefore any high harmonics generated more than 100nm from the output surface will be absorbed within the substrate. Figure 8(b) illustrates the configured solid HHG medium 800 in a second orientation, oriented to receive first radiation or drive radiation 805 on the structured side. In this orientation, the grating first modulates the drive radiation resulting in modulated drive radiation 815. This modulated drive radiation then causes HHG generation 820 on the unstructured side with a spatially modulated amplitude. This effect can boost the conversion efficiency.

Generating structured light can be interesting for metrology techniques, that rely on projecting a beam with the shape of a grating onto a physical grating on the metrology target (alignment sensor, overlay, level sensor), and for advanced super-resolution imaging techniques like structured illumination microscopy .

Figure 9 illustrates embodiments of a configured solid HHG medium for generating and focusing the generated light with a single optical element. This would combine the generation medium and focusing optic into a single element, leading to a HHG generation and illumination module that is very compact.

Figure 9(a) shows a configured solid HHG medium 900 comprising a curved (concave) outer generation surface which generates and focuses the high harmonic radiation, where the curved surface acts like a lens for the high harmonic radiation.

Figure 9(b) shows a configured solid HHG medium 910 comprising a zone plate; i.e., a flat substrate with non-equidistant concentric grooves 920 on the HHG side (output side). This results in the emission of a convergent, self-focusing HHG beam from the zone plate. More generally, the shape of the output HHG beam depends on the distribution of the grooves of the zone plate. Configure the grooves such that a convergent, self-focusing beam results is only one possible exemplary arrangement, and other groove arrangements are possible depending on the desired beam characteristic(s).

The arrangements of Figures 9(a) and (b) may be combined such that the configured solid HHG medium comprises a curved (concave) outer generation surface having thereon a zone plate.

Both the zone plate and curved (concave) outer generation surface will focus the different energies (harmonics) at different locations, which can be a potential benefit, as it enables variation of the spectral intensity on the sample by simply scanning the sample longitudinally through the chromatic focus, which gives additional spectral information of the sample. The downside is that the part of the spectrum that is out of focus may partially lie outside the sample, thereby probing the environment, which is generally regarded as unwanted. However, when scanning the sample, a systematic scan of wavelengths is also performed which probes the environment and provides the potential to identify and discriminate nuisance signal from the environment from the wanted signal from the sample. US patent application 20200201192 describes the benefits of chromatic focus position variation and is incorporated herein by reference.

A few preconditions may be respected to be able to use the concept of a self-focusing high harmonic beam in a realistic high harmonic-based metrology tool. One is that the focal spot of the self-focusing high harmonic beam is sufficiently small to be useful for metrology applications. Metrology targets on wafers may be on the order of or smaller than 50x50 $\mu$m, optionally 20x20 $\mu$m, optionally 10x10 $\mu$m in size (although larger targets may be measured as mentioned above). In one embodiment the focal spot radius $w_0$ may at most be about 5 $\mu$m. In general, $w_0$ depends on the distance z from generation point to the focus and on the radius w of the beam at the generation point. To estimate the required beam radius to obtain sufficiently small focal spot radius $w_0$, the high harmonic beam may be modelled as a Gaussian beam. In that case:

$$w \approx \frac{z\lambda}{\pi w_0}$$

with $\lambda$ the high harmonic wavelength. Typically, a clear distance of at least a few cm between the generation medium and the wafer is necessary to allow for insertion of apertures and filters to block the drive laser and prevent it from irradiating the sensitive IC wafer. Taking therefore a safe distance z = 10 cm, and a typical wavelength of 30 nm, the above equation yields a w greater than 190$\mu$m. Consequently, the drive laser beam may be at least this size at the position of the solid generation medium, and needs to be sufficiently intense to trigger the emission of high harmonic radiation. Typically, the required intensity may be about $10^{16}$ - $10^{17}$ W/m$^2$.

A second precondition for applying a self-focusing high harmonic beam in a metrology tool is that the drive laser radiation can be sufficiently blocked from irradiating the sensitive wafer. Very effective blocking may be achieved, for example, by applying a thin-film metal filter. However, such filters cannot withstand a high drive laser power, and therefore in high-power applications an additional blocking step is required before the filter. This additional blocking step may comprise using a laser beam which has an annular profile in a region sufficiently far from the drive laser focus, and blocking this annular beam by means of an aperture. Alternative methods for IR laser blocking may comprise the application of selective mirrors or a mesh grid to block the drive radiation. In any of these methods, it is required to insert optical components in the drive laser beam. For laser intensities common to gas-phase HHG, care has to be taken to place the optical components sufficiently far from the drive laser focus where the flux (i.e., the product of intensity and pulse length) is below the damage threshold of the optical component. In contrast, in solid-phase HHG the drive laser intensity is significantly lower, and optimized high-power optics can be made with damage thresholds comparable to that of the HHG-generating solid itself. Therefore optics damage due to close proximity of the drive laser focus does not present a problem.

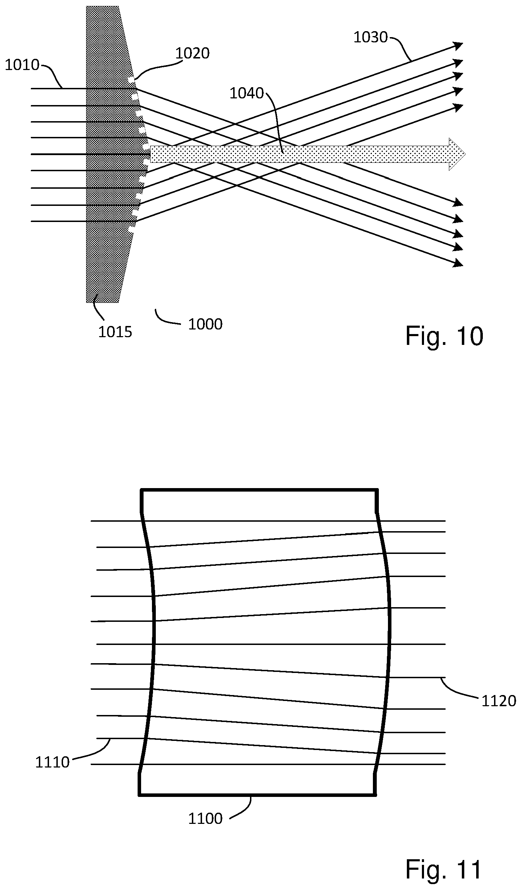

Figure 10 illustrates embodiments of a configured solid HHG medium 1000 which addresses the problem of filtering out the drive radiation 1010. Such a configured solid HHG medium 1000 can also be used in focusing the high harmonic beam. The configured solid HHG medium 1000 comprises an axicon-shaped solid substrate 1010 comprising concentric circular grooves 1020 on the HHG-generating side (output side). The concentric circular grooves 1020 may, for example, have a form (when viewed along the optical axis) as those of Figure 9(b). An axicon comprises a conical surface and can convert a laser light beam to an annular distribution. In this context, the axicon shape refracts the IR drive radiation 1010 into an annular beam distribution 1030, while the grooves 1020, assuming a constant groove spacing, diffract the high harmonic radiation 1040 into a collimated beam (substantially) along the optical axis. In another embodiment, the concentric circular grooves 1020 may comprise a Fresnel-type groove spacing which focuses the high harmonic radiation 1040 at a point along the optical axis. In this manner, the drive radiation can be blocked using a suitable dimensioned aperture centered on the optical axis. This element therefore can elegantly combine generation, IR removal and optionally focusing of the high harmonic radiation.

The axicon arrangement described above is only an example of an arrangement for separating the drive radiation from the HHG radiation. More generally, additional embodiments may comprise any configuration in which the shape of the solid is such that the drive radiation is refracted away from the axis, and compensating grooves are provided such that the harmonics are diffracted along the axis. The axicon geometry described above is only one such example of this class of configured solid HHG medium.

Figure 11 illustrates an embodiment of a configured solid HHG medium 1100 for generating flat-top beams (also called top-hat beams). In various metrology applications, it is desired to illuminate the sample with a homogenous intensity profile, in which case a top-hat beam profile may typically be used, i.e., a beam with near-uniform fluence within a circular disk. For visible light, optical elements are readily available (beam shapers) which convert a Gaussian beam into a top hat, but such optical elements are not available for EUV radiation.

The idea behind generating a top-hat high harmonic (e.g., EUV) beam 1120 relies on using a single configured solid HHG element 1100 which imprints a flat-top profile on the fundamental drive radiation beam 1110. This profile is then imprinted on the emitted EUV beam 1120. The actual shape of the optical element 1100 may be similar to that described in Zhang et al, Opt Express 11, 1942 (2003) (disclosed herein by reference). The input surface of the element 1100 refracts the collimated input beam 1110, which is then re-collimated by the output surface. The rays near the optical axis experience larger radial magnification then those further away from the optical axis. This redistributes the intensity of the beam in a uniform flat top distribution.

It should be noted that the generated high harmonic radiation 1120 at the exit surface will experience a different refractive index than that of the infrared driving field. The exit surface has to be shaped such that the EUV beam is turned into a top hat distribution, which will result in a different curvature than in the design consideration by Zhang et al. For example, compared to the design by Zhang et al., the radius of curvature of the exit surface has to be smaller (larger) if the refractive index difference at the exit-surface interface of the emitted high-harmonic radiation is smaller (larger) than the refractive-index difference of the driving laser. The exact design thus follows from the laws of refraction

Turning more generally to the topic of separating the drive radiation from the high harmonic radiation, it is expected that the high harmonic radiation and the drive radiation will refract in different directions at a surface, especially when this surface has an angle other than normal incidence, or is curved. This is simply due to the difference in refractive index. And if $n>1$ for IR but $n<1$ for EUV, they will actually diffract in opposite directions. This alone may be sufficient for achieving IR/EUV separation, without further need of shaping; a wedge would be sufficient. Subsequently, additional embodiments may further shape and steer the beam(s) as has been described above. As such, the overall shape of any elements disclosed herein may take into account the refractive index, and a wedge may be added as an additional element for separating the high harmonic and drive radiation. Strong variations in the refractive index as a function of photon energy may lead to chromatic aberrations.

Methods described herein may generate radiation with wavelengths shorter than 200nm, shorter than 160nm, shorter than 130nm, shorter than 100nm, shorter than 80nm, shorter than 70nm, shorter than 60nm, shorter than 50nm, shorter than 40nm, shorter than 30nm or shorter than 20nm.

The illumination source may be provided in for example a metrology apparatus MT, an inspection apparatus, a lithographic apparatus LA, and/or a lithographic cell LC.

The properties of the emitted radiation used to perform a measurement may affect the quality of the obtained measurement. For example, the shape and size of a transverse beam profile (cross-section) of the radiation beam, the intensity of the radiation, the power spectral density of the radiation etc., may affect the measurement performed by the radiation. It is therefore beneficial to have a source providing radiation that has properties resulting in high quality measurements.

Further embodiments are disclosed in the subsequent numbered clauses:

> 1. A metrology apparatus for measurement of a target formed on a substrate by a lithographic process, the metrology apparatus comprising:
>
>> a radiation source operable to provide first radiation;
>> a configured solid high harmonic generation medium being configured to receive and be excited by said first radiation to generate high harmonic second radiation from an output surface of the configured solid high harmonic generation medium; and

a detection arrangement operable to detect said second radiation, at least a portion of which having been scattered by said target;

wherein said configured solid high harmonic generation medium is configured to shape the beam of said second radiation and/or separate said first radiation and said second radiation.

2. A metrology apparatus as claimed in clause 1, wherein said configured solid high harmonic generation medium is configured to focus said second radiation onto said target.

3. A metrology apparatus as claimed in clause 2, wherein said output surface comprises a concave curvature to perform said focusing.

4. A metrology apparatus as claimed in clause 2 or 3, wherein said output surface comprises concentric circular grooves to perform said focusing.

5. A metrology apparatus as claimed in clause 4, wherein said concentric circular grooves comprise a Fresnel spacing arrangement.

6. A metrology apparatus as claimed in any preceding clause, wherein the configured solid high harmonic generation medium comprises a shape which refracts the drive radiation away from an optical axis of the configured solid high harmonic generation medium, and said output surface comprises compensating grooves such that the second radiation is diffracted substantially along the optical axis.

7. A metrology apparatus as claimed in clause 6, wherein the configured solid high harmonic generation medium comprises an axicon shape operable to impart an annular profile onto said first radiation; and concentric circular grooves on the output surface such that said second radiation is focused on and/or propagates substantially along said optical axis of the configured solid high harmonic generation medium.

8. A metrology apparatus as claimed in clause 7, wherein said concentric circular grooves comprise a Fresnel spacing arrangement.

9. A metrology apparatus as claimed in clause 7, wherein said concentric circular grooves are equally spaced apart.

10. A metrology apparatus as claimed in clause 7, 8 or 9, further comprising a spatial filter to block the first radiation and pass the second radiation.

11. A metrology apparatus as claimed in any preceding clause, comprising a grating structure on said output surface being operable to impose a phase modulation on said second radiation.

12. A metrology apparatus as claimed in clause 11, wherein said configured solid high harmonic generation medium is reversible such that, when reversed, said grating structure is comprised on an input surface of said configured solid high harmonic generation medium, and is operable to impose an amplitude modulation on said output radiation.

13. A metrology apparatus as claimed in clause 1, comprising a grating structure on an input surface of said configured solid high harmonic generation medium, being operable to impose an amplitude modulation on said second radiation.

14. A metrology apparatus as claimed in any preceding clause, wherein said configured solid high harmonic generation medium is configured such that it has a curved input surface and curved output surface, and such that refraction of the first radiation at the curved input surface, and refraction of the second radiation at the curved output surface, impart a substantially flat-top illumination profile on said second radiation.

15. A metrology apparatus as claimed in any preceding clause, wherein at least some harmonics of said second radiation comprise wavelengths shorter than 100nm, optionally shorter than 70nm.

16. A metrology apparatus as claimed in any preceding clause, wherein at least some harmonics of said second radiation comprise wavelengths shorter than 50nm.

17. A metrology apparatus as claimed in any preceding clause, wherein the first radiation is pulsed laser radiation.

18. A metrology apparatus as claimed in clause 17, wherein the length of each pulse is in the range of 1fs to 500fs

19. A metrology apparatus as claimed in any preceding clause, wherein the first radiation comprises a wavelength in the range of 100 nm to 3000 nm.

20. A metrology apparatus as claimed in any preceding clause, being configured such that the first radiation is incident on a first side of said substrate and the second radiation is emitted from a second side of said substrate, wherein the first side and the second side are different sides of said substrate.

21. A configured solid high harmonic generation medium comprising an axicon shape operable to impart an annular profile onto first radiation received at an input surface; and concentric circular grooves on an output surface such that high harmonic second radiation generated at said output surface resulting from excitation by said first radiation is focused on and/or propagates substantially along an optical axis of the configured solid high harmonic generation medium.

22. A configured solid high harmonic generation medium as claimed in clause 21, wherein said concentric circular grooves are equally spaced apart to provide a co-linear beam of second radiation.

23. A configured solid high harmonic generation medium as claimed in clause 21, wherein said concentric circular grooves comprise a Fresnel spacing arrangement to perform said focusing.

24. A metrology method for measuring a target formed on a substrate by a lithographic process comprising:

exciting a configured solid high harmonic generation medium with first radiation, to generate high harmonic second radiation from an output surface of the configured solid high harmonic generation medium and to shape the beam of said second radiation and/or separate said first radiation and said second radiation; and detecting said second radiation, at least a portion of which having been scattered by said target.

25. A method as claimed in clause 24, comprising focusing said second radiation onto said target using solid high harmonic generation medium.

26. A method as claimed in clause 25, wherein said output surface comprises a concave curvature to perform said focusing.

27. A method as claimed in clause 25 or 26, wherein said output surface comprises concentric circular grooves to perform said focusing.

28. A method as claimed in clause 27, wherein said concentric circular grooves comprise a Fresnel spacing arrangement.

29. A method as claimed in clause 24 or 25, comprising using the configured solid high harmonic generation medium to refract the drive radiation away from an optical axis of the configured solid high harmonic generation medium, and to diffract the second radiation substantially along the optical axis.

30. A method as claimed in clause 29, wherein the configured solid high harmonic generation medium comprises an axicon shape.

31. A method as claimed in clause 30, wherein said concentric circular grooves comprise a Fresnel spacing arrangement.

32. A method as claimed in clause 30, wherein said concentric circular grooves are equally spaced apart.

33. A method as claimed in clause 30, 31 or 32, further comprising blocking the first radiation and passing the second radiation before said target.

34. A method as claimed in clause 24, comprising imposing a phase modulation on said second radiation using a grating structure on said output surface.

35. A method as claimed in clause 34, comprising selecting an orientation of said high harmonic generation medium is reversible such that, to select whether to impose a phase modulation or amplitude modulation on said output radiation.

36. A method as claimed in clause 24, comprising imposing an amplitude modulation on said second radiation using a grating structure on an input surface of said configured solid high harmonic generation medium.

37. A method as claimed in clause 24, comprising using said solid high harmonic generation medium to impart a substantially flat-top illumination profile on said second radiation.

38. A method as claimed in any of clauses 24 to 37, wherein at least some harmonics of said second radiation comprise wavelengths shorter than 100nm.

39. A method as claimed in any of clauses 24 to 38, wherein at least some harmonics of said second radiation comprise wavelengths shorter than 70nm.

40. A method as claimed in any of clauses 24 to 39, wherein at least some harmonics of said second radiation comprise wavelengths shorter than 50nm.

41 A method as claimed in any of clauses 24 to 40, wherein the first radiation is pulsed laser radiation.

42. A method as claimed in clause 41, wherein the length of each pulse is in the range of 1fs to 500fs

43. A method as claimed in any of clauses 24 to 42, wherein the first radiation comprises a wavelength in the range of 100 nm to 3000 nm.

44. A configured solid high harmonic generation medium comprises an input surface operable to receive a first radiation; and an output surface operable to emit a high harmonic second radiation resulting from excitation by the first radiation, wherein the configured solid high harmonic generation medium is configured to shape beam of the second radiation and/or separate the first radiation and the second radiation.

45. A configured solid high harmonic generation medium as claimed in clause 44, wherein the configured solid high harmonic generation medium is shaped operable to refract the first radiation away from an optical axis of the configured solid high harmonic generation medium.

46. A configured solid high harmonic generation medium as claimed in clause 45, wherein the configured solid high harmonic generation medium comprises compensating grooves on the output surface being operable to diffract the second radiation substantially along the optical axis.

47. A configured solid high harmonic generation medium as claimed in clause 44 or 45, wherein the configured solid high harmonic generation medium comprises a grating structure on the output surface being operable to impose a phase modulation on the second radiation.

48. A configured solid high harmonic generation medium as claimed in clause 44 or 45, wherein both the input surface and the output surface are curved and are configured such that refraction of the first radiation at the input surface, and refraction of the second radiation at the output surface, impart a substantially flat-top illumination profile on the second radiation.

49. A configured solid high harmonic generation medium as claimed in clause 44 or 45, comprising an axicon shape operable to impart an annular profile onto first radiation; and concentric circular grooves on the output surface such that the second radiation generated is focused on and/or propagates substantially along an optical axis of the configured solid high harmonic generation medium.

50. A high harmonic generation source comprising configured a solid high harmonic generation medium according to any of clauses 44 to 49.

51. A metrology apparatus comprising a high harmonic generation source according to clause 50.

52. A metrology apparatus comprising a configured a solid high harmonic generation medium according to any of clauses 44 to 49.

53. A lithographic cell comprising a high harmonic generation source according to clause 50.

54. A lithographic cell comprising a metrology apparatus according to clause 52.

Although specific reference may be made in this text to the use of lithographic apparatus in the manufacture of ICs, it should be understood that the lithographic apparatus described herein may have other applications. Possible other applications include the manufacture of integrated optical systems, guidance and detection patterns for magnetic domain memories, flat-panel displays, liquid-crystal displays (LCDs), thin-film magnetic heads, etc.

Although specific reference may be made in this text to embodiments in the context of a lithographic apparatus, embodiments may be used in other apparatus. Embodiments may form part of a mask inspection apparatus, a metrology apparatus, or any apparatus that measures or processes an object such as a wafer (or other substrate) or mask (or other patterning device). These apparatuses may be generally referred to as lithographic tools. Such a lithographic tool may use vacuum conditions or ambient (non-vacuum) conditions.

Although specific reference may be made in this text to embodiments in the context of an inspection or metrology apparatus, embodiments may be used in other apparatus. Embodiments may form part of a mask inspection apparatus, a lithographic apparatus, or any apparatus that measures or processes an object such as a wafer (or other substrate) or mask (or other patterning device). The term "metrology apparatus" (or "inspection apparatus") may also refer to an inspection apparatus or an inspection system (or a metrology apparatus or a metrology system). E.g. the inspection apparatus that comprises an embodiment may be used to detect defects of a substrate or defects of structures on a substrate. In such an embodiment, a characteristic of interest of the structure on the substrate may relate to defects in the structure, the absence of a specific part of the structure, or the presence of an unwanted structure on the substrate.

Although specific reference may have been made above to the use of embodiments in the context of optical lithography, it will be appreciated that the invention, where the context allows, is not limited to optical lithography and may be used in other applications, for example imprint lithography.

While the targets or target structures (more generally structures on a substrate) described above are metrology target structures specifically designed and formed for the purposes of measurement, in other embodiments, properties of interest may be measured on one or more structures which are functional parts of devices formed on the substrate. Many devices have regular, grating-like structures. The terms structure, target grating and target structure as used herein do not require that the structure has been provided specifically for the measurement being performed. Further, pitch of the metrology targets may be close to the resolution limit of the optical system of the scatterometer or may be smaller, but may be much larger than the dimension of typical non-target structures optionally product structures made by lithographic process in the target portions C. In practice the lines and/or spaces of the overlay gratings within the target structures may be made to include smaller structures similar in dimension to the non-target structures.

While specific embodiments have been described above, it will be appreciated that the invention may be practiced otherwise than as described. The descriptions above are intended to be illustrative, not limiting. Thus it will be apparent to one skilled in the art that modifications may be made to the invention as described without departing from the scope of the claims set out below.

Although specific reference is made to "metrology apparatus / tool / system" or "inspection apparatus / tool / system", these terms may refer to the same or similar types of tools, apparatuses or systems. E.g. the inspection or metrology apparatus that comprises an embodiment of the invention may be used to determine characteristics of structures on a substrate or on a wafer. E.g. the inspection apparatus or metrology apparatus that comprises an embodiment of the invention may be used to detect defects of a substrate or defects of structures on a substrate or on a wafer. In such an embodiment, a characteristic of interest of the structure on the substrate may relate to defects in the structure, the absence of a specific part of the structure, or the presence of an unwanted structure on the substrate or on the wafer.

Although specific reference is made to SXR and EUV electromagnetic radiations, it will be appreciated that the invention, where the context allows, may be practiced with all electromagnetic radiations, includes radio waves, microwaves, infrared, (visible) light, ultraviolet, X-rays, and gamma rays. As an alternative to optical metrology methods, it has also been considered to use X-rays, optionally hard X-rays, for example radiation in a wavelength range below O.Olnm or between O.Olnm and 10nm, or optionally between O.Olnm and 0.5nm, or optionally between O.Olnm and 0.1nm, for metrology measurements.

While specific embodiments have been described above, it will be appreciated that one or more of the features in one embodiment may also be present in a different embodiment and that features in two or more different embodiments may also be combined.

**Claims**

1. A metrology apparatus for measurement of a target formed on a substrate by a lithographic process, the metrology apparatus comprising:

   a radiation source operable to provide first radiation;
   a configured solid high harmonic generation medium being configured to receive and be excited by said first radiation to generate high harmonic second radiation from an output surface of the configured solid high harmonic generation medium; and
   a detection arrangement operable to detect said second radiation, at least a portion of which having been scattered by said target;
   wherein said configured solid high harmonic generation medium is configured to shape the beam of said second radiation and/or separate said first radiation and said second radiation.

2. A metrology apparatus as claimed in claim 1, wherein said configured solid high harmonic generation medium is configured to focus said second radiation onto said target.

3. A metrology apparatus as claimed in claim 2, wherein said output surface comprises a concave curvature to perform said focusing.

4. A metrology apparatus as claimed in any preceding claim, wherein the configured solid high harmonic generation medium comprises a shape which refracts the drive radiation away from an optical axis of the configured solid high harmonic generation medium, and optionally said output surface comprises compensating grooves such that the second radiation is diffracted substantially along the optical axis.

5. A metrology apparatus as claimed in claim 4, wherein the configured solid high harmonic generation medium comprises an axicon shape operable to impart an annular profile onto said first radiation.

6. A metrology apparatus as claimed in any preceding claim, comprising a grating structure on said output surface being operable to impose a phase modulation on said second radiation.

7. A metrology apparatus as claimed in any preceding claim, wherein said configured solid high harmonic generation medium is configured such that it has a curved input surface and curved output surface, and such that refraction of the first radiation at the curved input surface, and refraction of the second radiation at the curved output surface, impart a substantially flat-top illumination profile on said second radiation.

8. A metrology apparatus as claimed in any preceding claim, wherein at least some harmonics of said second radiation comprise wavelengths shorter than 100nm, optionally shorter than 70nm, optionally shorter than 50nm.

9. A metrology apparatus as claimed in any preceding claim, being configured such that the first radiation is incident on a first side of said substrate and the second radiation is emitted from a second side of said substrate, wherein the first side and the second side are different sides of said substrate.

10. A configured solid high harmonic generation medium comprises an input surface operable to receive a first radiation; and an output surface operable to emit a high harmonic second radiation resulting from excitation by the first radiation, wherein the configured solid high harmonic generation medium is configured to shape beam of the second radiation and/or separate the first radiation and the second radiation.

11. A configured solid high harmonic generation medium as claimed in claim 10, wherein the configured solid high harmonic generation medium is shaped operable to refract the first radiation away from an optical axis of the configured solid high harmonic generation medium.

12. A configured solid high harmonic generation medium as claimed in claim 11, wherein the configured solid high harmonic generation medium comprises compensating grooves on the output surface being operable to diffract the second radiation substantially along the optical axis.

13. A configured solid high harmonic generation medium as claimed in claim 10 or 11, wherein the configured solid high harmonic generation medium comprises a grating structure on the output surface being operable to impose a phase modulation on the second radiation.

14. A configured solid high harmonic generation medium as claimed in claim 10 or 11, wherein both the input surface and the output surface are curved and are configured such that refraction of the first radiation at the input surface, and refraction of the second radiation at the output surface, impart a substantially flat-top illumination profile on the second radiation.

15. A configured solid high harmonic generation medium as claimed in claim 10 or 11, comprising an axicon shape operable to impart an annular profile onto first radiation; and concentric circular grooves on the output surface such that the second radiation generated is focused on and/or propagates substantially along an optical axis of the configured solid high harmonic generation medium.

Fig. 1

Fig. 2

Fig. 3

LA

SC1

SC3

CL

-1    0    +1

SC2

MT

SM1

2

4

PU

Z

X

W

Fig. 4

I

6

λ

Z

8

X

SM1

Fig. 5

Fig. 6

Fig. 7

(a)

(b)

Fig. 8

(a)

(b)

Fig. 9

Fig. 10

Fig. 11

**EP 4 006 641 A1**

Europäisches
Patentamt

European
Patent Office

Office européen
des brevets

# EUROPEAN SEARCH REPORT

Application Number

EP 20 21 0697

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | TAUCER MARCO ET AL: "Controlling High Harmonic Generation in Tailored Semiconductors", 2018 CONFERENCE ON LASERS AND ELECTRO-OPTICS (CLEO), OSA, 13 May 2018 (2018-05-13), pages 1-2, XP033380657, [retrieved on 2018-08-06] | 10 | INV. G03F7/20 G02F1/35 |
| Y | * the whole document * | 1,2,8,9 | |
| X | FEDELI L ET AL: "Structured targets for advanced laser-driven sources", PLASMA PHYSICS AND CONTROLLED FUSION, IOP, BRISTOL, GB, vol. 60, no. 1, 6 November 2017 (2017-11-06), page 14013, XP020322892, ISSN: 0741-3335, DOI: 10.1088/1361-6587/AA8A54 [retrieved on 2017-11-06] | 10 | |
| Y | * the whole document * | 1 | TECHNICAL FIELDS SEARCHED (IPC) |
| Y | EP 3 321 739 A1 (ASML NETHERLANDS BV [NL]) 16 May 2018 (2018-05-16) * paragraphs [0045] - [0048]; figure 4 * | 1,2,8,9 | G03F G02F |
| A | JP 2009 200533 A (NIPPON SHEET GLASS CO LTD) 3 September 2009 (2009-09-03) * abstract; figures 1, 2 * | 1-15 | |

The present search report has been drawn up for all claims

| Place of search | Date of completion of the search | Examiner |
|---|---|---|
| Munich | 12 May 2021 | Eisner, Klaus |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

EP 4 006 641 A1

**ANNEX TO THE EUROPEAN SEARCH REPORT
ON EUROPEAN PATENT APPLICATION NO.**

EP 20 21 0697

This annex lists the patent family members relating to the patent documents cited in the above-mentioned European search report.
The members are as contained in the European Patent Office EDP file on
The European Patent Office is in no way liable for these particulars which are merely given for the purpose of information.

12-05-2021

| Patent document cited in search report | | Publication date | Patent family member(s) | | Publication date |
|---|---|---|---|---|---|
| EP 3321739 | A1 | 16-05-2018 | CN | 110268329 A | 20-09-2019 |
| | | | EP | 3321739 A1 | 16-05-2018 |
| | | | JP | 2019536995 A | 19-12-2019 |
| | | | KR | 20190074316 A | 27-06-2019 |
| | | | TW | 201820053 A | 01-06-2018 |
| | | | US | 2018136568 A1 | 17-05-2018 |
| | | | WO | 2018086816 A2 | 17-05-2018 |
| JP 2009200533 | A | 03-09-2009 | NONE | | |

EPO FORM P0459

For more details about this annex : see Official Journal of the European Patent Office, No. 12/82

25

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2006066855 A1
- US 2011102753 A1
- US 20120044470 A
- US 6952253 B
- US 20100328655 A
- US 20110249244 A
- US 20110026032 A
- EP 1628164 A
- US 451599
- US 11708678 B
- US 12256780 B
- US 12486449 B
- US 12920968 B
- US 12922587 B

- US 13000229 B
- US 13033135 B
- US 13533110 B
- US 13891410 B
- WO 2011012624 A
- US 20160161863 A
- US 20160370717 A1
- US 2007224518 A
- US 20130304424 A1
- US 2014019097 A1, Bakeman
- US 20170184981 A1
- US 2016282282 A1
- US 20200201192 A

**Non-patent literature cited in the description**

- **P. M. KRAUS.** *Ultrafast extreme-ultraviolet emission from solids, EUV Source Workshop Proceedings,* 11 April 2020

- **ZHANG et al.** *Opt Express,* 2003, vol. 11, 1942